# DEMANDE DE BREVET EUROPEEN

(11) **EP 2 060 534 A1**
(43) Date de publication de la demande: **20.05.2009**
(21) Numéro de dépôt: 07120883.9
(22) Date de dépôt: 16.11.2007
(51) Int. Cl.: B81C 5/00, C25D 1/00, G04B 13/00

(54) **Pièce de micromécanique composite silicium - métal et son procédé de fabrication**

(71) Demandeur: Nivarox-FAR S.A., CH-2400 Le Locle (CH)
(72) Inventeur: Fiaccabrino, Jean-Charles, 1421, Grandevent (CH); Verardo, Marco, 2336, Les Bois (CH); Conus, Thierry, 2543, Lengnau (CH); Thiébaud, Jean-Philippe, 1588, Cudrefin (CH); Peters, Jean-Bernard, 2300, La Chaux-de-Fonds (CH)
(74) Mandataire: Couillard, Yann Luc Raymond

(57) **Abrégé**

L'invention se rapporte à un procédé de fabrication (1) d'une pièce de micromécanique (51) composite silicium - métal combinant des processus du type DRIE et LIGA.
L'invention se rapporte également à une pièce de micromécanique (51) comprenant une couche dans laquelle une partie (53) est en silicium et une autre (41) en métal afin de former une pièce de micromécanique (51) du type composite.
L'invention concerne le domaine des mouvements horlogers.

## Description

### DOMAINE DE L'INVENTION

L'invention se rapporte à une pièce de micromécanique composite silicium - métal et son procédé de fabrication.

### ARRIERE PLAN DE L'INVENTION

Le silicium est connu tribologiquement pour son faible coefficient de frottement. Son application dans l'horlogerie mécanique est Intéressante notamment pour les systèmes d'échappement et plus précisément pour les pignons d'impulsion d'une roue d'échappement. Cependant, le silicium est également connu mécaniquement pour sa faible zone plastique de sorte que son adaptation notamment aux techniques habituelles de chassage sur axe est rendue difficile par son caractère cassant.

### RESUME DE L'INVENTION

Le but de la présente invention est de pallier tout ou partie les inconvénients cités précédemment en proposant un procédé de fabrication permettant avantageusement la réalisation d'une pièce de micromécanique composite apte à s'adapter à la plupart des applications horlogères.

A cet effet, l'invention se rapporte à un procédé de fabrication d'une pièce de micromécanique composite silicium - métal comprenant les étapes suivantes :
a) se munir d'un substrat comportant une couche supérieure et une couche inférieure en silicium entre lesquelles s'étend une couche intermédiaire d'oxyde de silicium ;
b) graver sélectivement au moins une cavité dans la couche supérieure pour définir le motif d'une partie en silicium de ladite pièce ;
c) continuer la gravure de ladite au moins une cavité dans la couche intermédiaire ;
   caractérisé en ce qu'il comporte en outre les étapes suivantes :
d) faire croître une couche métallique au moins à partir d'une portion de ladite au moins une cavité afin de former une partie métallique dans l'épaisseur de ladite pièce ;
e) libérer la pièce de micromécanique composite silicium - métal du substrat.

Le procédé permet avantageusement d'obtenir une pièce monobloc qui permet de jouir des caractéristiques tribologiques du silicium et des caractéristiques mécaniques du métal.

Conformément à d'autres caractéristiques avantageuses de l'invention :
- l'étape d) comporte les étapes suivantes :

- recouvrir de résine photosensible le dessus du substrat ;
- réaliser sélectivement une photolithographie de la résine photosensible afin de la photostructurer en fonction du motif prédéterminé de la partie métallique ;
- déposer une couche métallique par électrodéposition à partir de la face supérieure conductrice de la couche inférieure qui est à l'aplomb de ladite au moins une cavité en y faisant croître, à partir du fond, la couche entre respectivement la résine photostructurée et la couche intermédiaire ou supérieure permettant de former la partie métallique selon ledit motif ;
- et en ce que l'étape e) est réalisée en éliminant la résine photostructurée.
- ladite face supérieure conductrice de la couche inférieure qui est à l'aplomb de ladite au moins une cavité est rendue conductrice par dopage de la couche inférieure et/ou par dépôt d'une couche conductrice ;
- ladite face supérieure conductrice de la couche inférieure qui est à l'aplomb de ladite au moins une cavité est rendue conductrice par dopage de la couche inférieure et/ou par dépôt d'une couche conductrice ;
- la résine photostructurée lors de l'étape de photolithographie fait saillie de la couche supérieure du substrat afin de pouvoir continuer la croissance de la couche par électrodéposition au moins entre lesdites saillies de la résine photostructurée dans le but de former une deuxième partie métallique de la pièce de micromécanique au-dessus de la partie en silicium ;
- le procédé comporte, après l'étape d), une étape d'usinage de la face supérieure du substrat afin de niveler la couche métallique à la même hauteur que l'extrémité supérieure de ladite résine photostructurée ;
- la couche métallique comporte du nickel ;
- le procédé comporte, avant l'étape de libération, des étapes d'usinage et de gravage d'au moins une cavité dans la couche inférieure du substrat afin de former une seconde partie en silicium de la pièce de micromécanique selon une forme et une épaisseur déterminée ;
- le procédé comporte, entre les étapes d'usinage et de gravage de la couche inférieure du substrat et l'étape de libération, une étape de croissance d'une deuxième couche métallique par électrodéposition dans au moins une portion de ladite au moins une cavité de la couche inférieure afin de former au moins une partie métallique supplémentaire dans l'épaisseur de la couche inférieure ;
- l'étape de croissance comporte les étapes suivantes :

- recouvrir de résine photosensible le dessous du substrat ;
- réaliser sélectivement une photolithographie de la résine photosensible afin de la photostructurer en fonction du motif prédéterminé de la partie métallique ;
- déposer une couche métallique par électrodéposition à partir du fond de ladite au moins une cavité en y faisant croître, à partir du fond, la couche permettant de former la partie métallique selon ledit motif ;
- la résine photostructurée lors de l'étape de photolithographie fait saillie de la couche inférieure du substrat afin de pouvoir continuer la croissance de la couche par électrodéposition dans le but de former une deuxième partie métallique supplémentaire de la pièce de micromécanique en dessous de la deuxième partie en silicium ;
- le procédé comporte, avant l'étape de libération, une étape d'usinage de la face inférieure du substrat afin de niveler la partie métallique à la même hauteur que l'extrémité inférieure de ladite résine photostructurée ;
- la deuxième couche métallique électrodéposée comporte du nickel ;
- plusieurs pièces de micromécanique sont fabriquées sur le même substrat.

L'invention se rapporte également à une pièce de micromécanique composite silicium - métal comportant une partie formée dans une couche en silicium caractérisée en ce que ladite partie en silicium comporte, au moins sur une portion de son épaisseur, une partie métallique d'une épaisseur supérieure à 6 microns destinée à isoler la partie en silicium d'efforts destructifs.

La pièce monobloc permet donc de profiter des caractéristiques tribologiques du silicium et des caractéristiques mécaniques du métal.

Conformément à d'autres caractéristiques avantageuses de l'invention :
- la partie métallique forme une chemise qui recouvre la paroi périphérique de ladite partie en silicium ;
- la partie métallique forme une chemise dans une cavité réalisée dans la partie en silicium afin de recevoir par chassage un axe de pivotement ;
- chaque chemise est reliée à la paroi de la partie en silicium par des ponts de matière ;
- chaque partie métallique comporte dans son prolongement une deuxième partie métallique faisant saillie de la partie en silicium ;
- la deuxième partie métallique comporte une denture afin de former une roue ou un pignon ;
- chaque partie métallique comportent du nickel ;
- la partie en silicium comprend une denture afin de former une roue ou un pignon ;
- la pièce comporte une deuxième partie en silicium formée à partir d'une deuxième couche ;
- la deuxième partie en silicium comporte au moins sur une portion de son épaisseur une partie supplémentaire métallique destinée à isoler la deuxième partie en silicium d'efforts destructifs ;
- la partie supplémentaire métallique forme une chemise dans une cavité réalisée dans la deuxième partie en silicium afin de recevoir par chassage un axe de pivotement ;
- ladite chemise est reliée à la paroi de ladite cavité par des ponts de matière ;
- la partie supplémentaire métallique comporte dans son prolongement une deuxième partie supplémentaire métallique faisant saillie de la deuxième partie en silicium ;
- la deuxième partie supplémentaire métallique comporte une denture afin de former une roue ou un pignon ;
- la deuxième partie en silicium est montée sur la partie en silicium à l'aide d'une couche intermédiaire en oxyde de silicium ;
- la deuxième partie en silicium comprend une denture afin de former une roue ou un pignon.

Enfin, l'invention se rapporte à une pièce d'horlogerie caractérisée en ce qu'elle comporte au moins une pièce de micromécanique composite conforme à l'une des variantes précédentes.

### DESCRIPTION SOMMAIRE DES DESSINS

D'autres particularités et avantages ressortiront clairement de la description qui en est faite ci-après, à titre indicatif et nullement limitatif, en référence aux dessins annexés, dans lesquels :
- les figures 1 à 7 sont des sections d'une pièce de micromécanique composite à différentes phases du procédé de fabrication selon l'invention ;
- la figure 1b est une représentation de la figure 1 en perspective.
- la figure 8 est une représentation d'un premier exemple d'étape finale selon le procédé de l'invention ;
- la figure 9 est une représentation d'un deuxième exemple d'étape finale selon le procédé de l'invention ;
- la figure 10 est un schéma fonctionnel du procédé de fabrication selon l'invention ;
- la figure 11 est une représentation en perspective d'un rouage selon l'invention ;
- la figure 12 est une représentation vue de dessus d'une aiguille obtenue selon l'invention ;

### DESCRIPTION DETAILLEE DES MODES DE REALISATION PREFERES

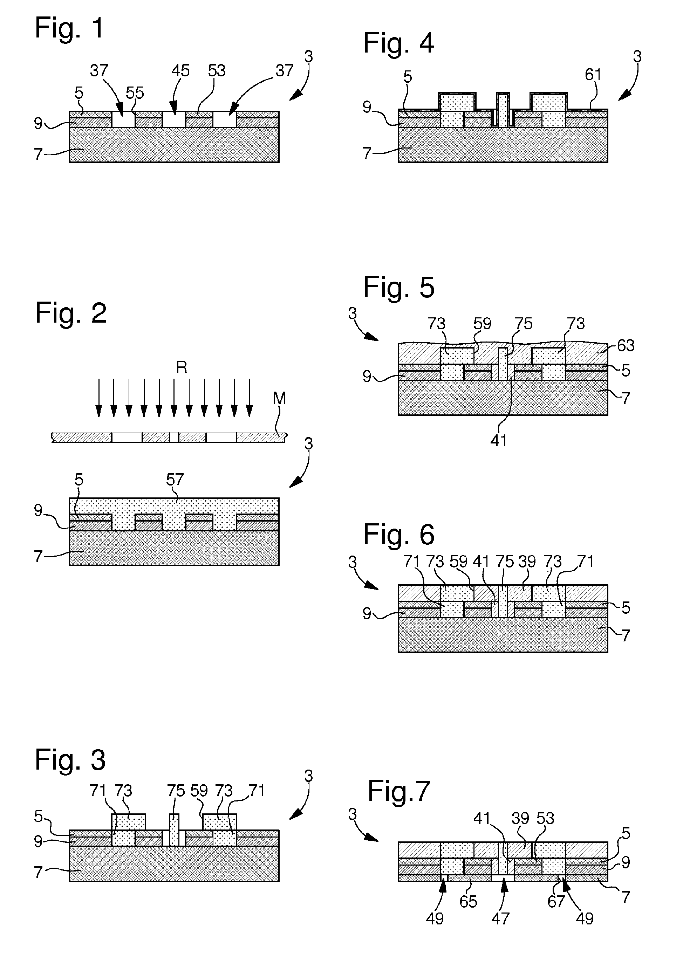

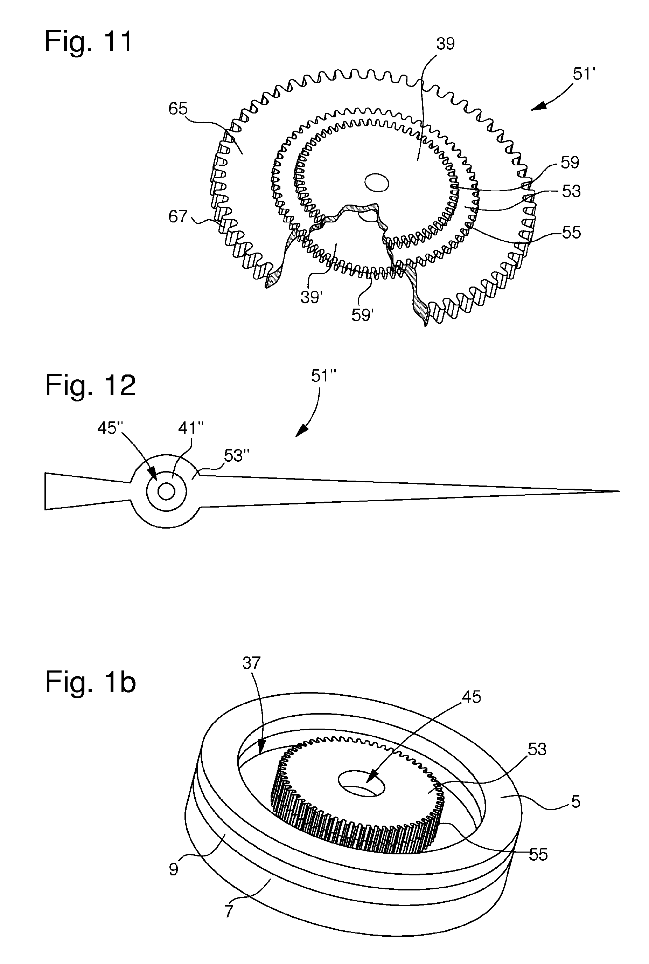

L'invention se rapporte à un procédé de fabrication 1 d'une pièce de micromécanique composite 51 silicium - métal. Comme visible aux figures 1 à 7, le procédé 1 comporte des étapes successives destinées à former au moins une pièce 51, 51', 51'', 51''' qui peut être complexe et/ou sur plusieurs couches et/ou avec plusieurs matériaux. Le but du présent procédé 1 consiste au minimum à offrir une pièce comportant au moins une partie en silicium et au moins une partie en métal.

La première étape 11 consiste à se munir d'un substrat 3 du type « silicium sur isolant », très connu sous l'acronyme anglais « SOI ». Le substrat 3 comporte une couche supérieure 5 et une couche inférieure 7 composées de silicium mono ou polycristallin. Entre les couches supérieure 5 et inférieure 7 s'étend une couche intermédiaire 9 composée d'oxyde de silicium du type amorphe (SiO₂).

Préférentiellement dans cette étape 11, le substrat 3 est choisi afin que, comme visible à la figure 1, la hauteur des couches supérieure 5 et intermédiaire 9 corresponde à la hauteur finale d'une partie 53 de la pièce de micromécanique finale 51.

Dans une deuxième étape 13, comme visible aux figures 1 & 1b, des cavités 37, 45 sont sélectivement gravées, par exemple par un procédé du type DRIE (acronyme très connu provenant de l'anglais « deep reactive ion etching »), dans la couche supérieure 5 en silicium. Ces deux cavités 37 et 45 permettent de former le motif définissant les contours intérieur et extérieur de la partie 53 en silicium de la pièce de micromécanique 51.

Dans l'exemple illustré à la figure 1, la cavité 37 est présente de chaque côté de la cavité 45 car, comme visible à la figure 1b, elle est sensiblement annulaire et entoure la cavité 45. Préférentiellement, la paroi proximale de la cavité 37 est sélectivement gravée afin de former une denture 55 sur le bord périphérique de la partie 53. La cavité 45 est sensiblement cylindrique à section discoïdale et est coaxiale par rapport à la cavité annulaire 37.

Dans une troisième étape 15, un gravage par attaque chimique humide ou sèche est réalisée pour prolonger, dans la couche intermédiaire 9, les cavités 37 et 45 afin que la partie 53 soit formée selon le même motif dans la couche intermédiaire 9 jusqu'à découvrir partiellement la couche inférieure 7.

Le procédé 1 selon l'invention comporte ensuite la mise en oeuvre d'un processus 19 du type LIGA (acronyme très connu provenant de l'allemand « Rôntgenlithographie, Galvanoformung & Abformung ») comportant une succession d'étapes (17, 21 & 23) permettant d'électrodéposer selon une forme particulière un métal sur la face supérieure du substrat 3 à l'aide d'une résine photostructurée.

Dans une quatrième étape 17, on dépose, sur la face supérieure du substrat 3, une couche de résine photosensible 57 comme visible à la figure 2. L'étape 17 peut être réalisée par exemple à l'aide d'un procédé du type coulée par moule (connu également sous les termes anglais « mould casting »). Préférentiellement, la résine photosensible 57 est du type Su-8 par exemple le produit « nano^{™} Su-8 » de l'entreprise Microchem Corp.

Dans une cinquième étape 21, on réalise une photolithographie, c'est-à-dire qu'on expose sélectivement à un rayonnement R, au moyen par exemple d'un masque M partiellement ajouré comme visible à la figure 2, pour réaliser une impression de ladite résine. Ensuite, on développe la résine 57, c'est-à-dire qu'on retire toutes les portions de la résine 57 qui n'ont pas été exposées au rayonnement R. La résine ainsi photostructurée 71, 73 & 75 permet de réaliser, selon la forme particulière prédéterminée, la couche métallique.

Dans l'exemple de la figure 3, la résine photostructurée comporte un anneau inférieur 71, un anneau supérieur 73 et un cylindre 75. Dans l'exemple de la figure 3, l'anneau inférieur 71 est de forme correspondante à la cavité 37. L'anneau supérieur 73 recouvre l'anneau inférieur 71 et, partiellement, la couche supérieure 5 du substrat 3. Enfin, le cylindre 75 possède une hauteur sensiblement équivalente à l'épaisseur de l'empilement des anneaux 71 et 73 et est monté centré dans la cavité 45. Dans l'exemple illustré aux figures 1 à 12, le diamètre intérieur de l'anneau supérieur 73 comporte une denture 59.

Préférentiellement dans une sixième étape 29, on dépose sur la face supérieure du substrat 3 une couche 61 d'accrochage conductrice comme visible à la figure 4. Cette étape peut être réalisée par exemple par un procédé conventionnel de métallisation sous vide par pulvérisation cathodique. Préférentiellement, la couche 61 comporte de l'or, c'est-à-dire de l'or pur ou un de ses alliages. L'épaisseur de la couche 61 peut être comprise entre 10 et 100 nm.

Dans une septième étape 23, on réalise par électrodéposition le départ d'une couche métallique sur la face supérieure du substrat 3, c'est-à-dire que l'on fait croître un couche 63 métallique afin de former au moins une partie métallique 41 de la pièce de micromécanique 51. Dans l'exemple illustré à la figure 5, la couche 63 commence sensiblement sur la face supérieure de la couche inférieure 7 mise à nue par la cavité 45.

La présence du cylindre 75 de résine photostructurée oblige la croissance de la couche métallique 63 à se former par couches annulaires successives entre le cylindre 75 et la couche intermédiaire 9 puis entre le cylindre 75 et la couche supérieure 5 du substrat 3. Cette première phase d'électrodéposition permet de former une première partie 41 métallique dans au moins une portion de la cavité 45.

On comprend donc à cette première phase de l'étape 23 que la pièce de micromécanique 51 est désormais formée sur une couche qui comporte une partie 53 en silicium et en oxyde de silicium dont au moins une portion d'une des cavités 45 comporte une partie 41 métallique.

Dans l'exemple illustré à la figure 5, l'électrodéposition est continuée ce qui forme des couches non plus dans la cavité 45 mais au-dessus et également sur une partie de la couche supérieure 5 du substrat 3. Les couches successives sont alors formées exclusivement entre l'anneau supérieur 73 et le cylindre 75 de résine photostructurée. On comprend donc que la couche 39 formée dans la deuxième phase est de forme sensiblement annulaire dont le diamètre extérieur comporte une denture inverse à celle 59 de l'anneau supérieur 73 en résine photostructurée. A la fin de l'étape 23, il peut arriver qu'on obtienne une couche 63 de métal sur toute la face supérieure du substrat 3 comme visible à la figure 5.

Préférentiellement, la couche 63, c'est-à-dire notamment les parties métalliques 39 et 41 comporte du nickel, c'est-à-dire du nickel pur ou un de ses alliages. Préférentiellement, la différence de potentiel du substrat 3 nécessaire à l'étape 23 d'électrodéposition est réalisée par contact sur sa face inférieure et/ou supérieure.

Dans une huitième étape 25, un usinage de la face supérieure du substrat 3 est réalisée, par exemple par rodage, afin de niveler la hauteur de la partie métallique 39, obtenue lors ladite deuxième phase de l'étape 23, par rapport à l'épaisseur de l'anneau supérieur 73 et du cylindre 75 en la résine photostructurée comme visible à la figure 6. Cela permet notamment de correctement délimiter la deuxième partie 39 métallique comportant la denture inverse (ci-après référencée 59).

On comprend donc à cette étape 25 que la pièce de micromécanique 51 est désormais formée sur deux couches. La première couche comporte une partie 53 en silicium et en oxyde de silicium dont au moins une portion d'une des cavités 45 comporte une partie 41 métallique. La deuxième couche formée au-dessus de la première est formée par une deuxième partie 39 métallique.

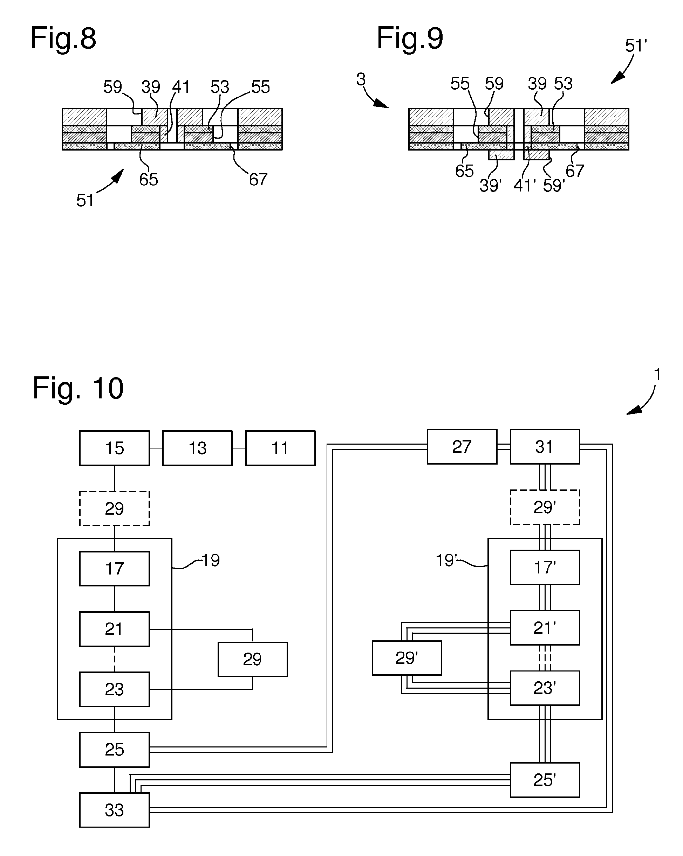

Dans des neuvième et dixième étapes 27 & 31, comme illustré par les doubles traits à la figure 10, on forme une deuxième partie 65 en silicium dans la couche inférieure 7 du substrat 3. Lors de l'étape 27, un usinage est réalisé sur la face inférieure du substrat 3 afin de diminuer l'épaisseur jusqu'à la valeur de la couche inférieure 7 finale souhaitée. Lors de l'étape 31, des cavités 47, 49 sont gravées, par exemple par un procédé du type DRIE, dans la couche inférieure 7 en silicium. Ces deux cavités 47 et 49, de la même manière que pour les étapes 13 & 15, permettent de former le motif définissant le contour de la deuxième partie 65 en silicium de la pièce de micromécanique 51.

Dans l'exemple illustré à la figure 7, la cavité 49 est présente de chaque côté de la cavité 47 car elle est sensiblement annulaire et entoure la cavité 47. Préférentiellement, la paroi proximale de la cavité 49 est sélectivement gravée afin de former une denture 67 sur le bord périphérique de la deuxième partie 65. La cavité 47 est sensiblement cylindrique à section discoïdale et coaxiale par rapport à la cavité annulaire 49.

Les étapes 27 et 31 n'ont pas une consécutivité préférée, de sorte que l'une peut être initiée avant l'autre et inversement. Préférentiellement, l'étape 27 d'usinage peut consister en un polissage mécano-chimique comme un rodage par abrasion chimique.

On comprend donc que, après ces étapes 27 & 31, la pièce de micromécanique 51 est désormais formée sur trois couches. La première couche comporte une partie 53 en silicium et en oxyde de silicium dont au moins une portion d'une des cavités 45 comporte une partie 41 métallique. La deuxième couche au-dessus de la première est formée par une deuxième partie 39 métallique. La troisième couche en dessous de la première est formée par une deuxième partie 65 en silicium.

Le procédé 1 selon l'invention comporte ensuite, comme illustré par les triples traits à la figure 10, la mise en oeuvre d'un nouveau processus 19' du type LIGA comportant une succession d'étapes (17', 21' & 23') permettant d'électrodéposer selon une forme particulière un métal sur la face inférieure du substrat 3 à l'aide d'une résine photostructurée.

Dans une onzième étape 17', on dépose sur la face inférieure du substrat 3 une couche de résine photosensible, par exemple à l'aide d'un procédé du type coulée par moule. Dans une douzième étape 21', on réalise une photolithographie permettant de réaliser le motif de la croissance de la future électrodéposition métallique.

Préférentiellement dans une treizième étape 29', on dépose sur la face inférieure du substrat 3 une couche d'accrochage. Cette étape peut être réalisée, par exemple, par dépôt sous vide, comme mentionné ci-dessus, d'une couche d'or pur ou un de ses alliages.

Dans une quatorzième étape 23', on réalise par électrodéposition une couche métallique sur la face inférieure du substrat 3 afin de former au moins une partie supplémentaire métallique 41' de la pièce de micromécanique 51 dans au moins une portion de la cavité 47.

On comprend donc à cette étape que la pièce de micromécanique 51 est toujours formée sur trois couches. La première couche comporte une partie 53 en silicium et en oxyde de silicium dont au moins une portion d'une des cavités 45 comporte une partie 41 métallique. La deuxième couche au-dessus de la première est formée par une deuxième partie 39 métallique. La troisième couche en dessous de la première est formée par une deuxième partie 65 en silicium dont au moins une portion d'une des cavités 47 comporte une partie supplémentaire 41' métallique.

L'étape 23' d'électrodéposition peut être continuée afin de former des couches non plus dans la cavité 47 mais en dessous et, éventuellement, sur une partie de la couche inférieure 7 du substrat 3. Les couches successives sont alors formées exclusivement entre la résine, photostructurée lors de l'étape 21', en une deuxième partie supplémentaire 39' métallique.

Préférentiellement, la couche métallique électrodéposée, c'est-à-dire notamment les parties métalliques supplémentaires 39' et 41' comporte du nickel, c'est-à-dire du nickel pur ou un de ses alliages.

Dans une quinzième étape 25', un usinage de la face inférieure du substrat 3 est réalisée, par exemple par rodage, afin de correctement délimiter la deuxième partie supplémentaire métallique 39'. De manière similaire à la deuxième partie 39, la deuxième partie supplémentaire 39' métallique peut également comporter une denture 59'.

On comprend donc à cette étape que la pièce de micromécanique 51 est désormais formée sur quatre couches. La première couche comporte une partie 53 en silicium & en oxyde de silicium dont au moins une portion d'une des cavités 45 comporte une partie 41 métallique. La deuxième couche au-dessus de la première est formée par une deuxième partie 39 métallique. La troisième couche en dessous de la première est formée par une deuxième partie 65 en silicium dont au moins une portion d'une des cavités 47 comporte une partie supplémentaire 41' métallique. La quatrième couche en dessous de la troisième est formée par une deuxième partie supplémentaire 39' métallique.

Bien entendu, l'intérêt d'un tel procédé est aussi de permettre, avantageusement, la réalisation de plusieurs pièces de micromécanique 51 sur un même substrat 3. De plus, à l'aide de l'explication ci-dessus et des traits simple, double et triple de la figure 10, il faut comprendre que le procédé 1 peut ne pas être entièrement réalisé, c'est-à-dire que suivant la complexité de la pièce de micromécanique 51 à fabriquer, on peut achever sa construction, par exemple, après l'étape 25, 31 ou 25'. Néanmoins pour chaque variante de construction, le procédé 1 comporte une dernière étape 33 consistant à libérer la pièce de micromécanique 51 du substrat 3. A titre d'exemples, il est expliqué ci-après plusieurs modes de réalisation du procédé 1 et/ou de la pièce de micromécanique 51.

Dans un premier mode de réalisation, l'étape de libération 33 du procédé 1 est réalisée après l'étape 25 de construction de la partie métallique 41 dans la partie 53 en silicium comme visualisé par les simples traits à la figure 10. L'étape de libération 33 consiste alors à éliminer la couche inférieure 7 ou les couches inférieure 7 et intermédiaire 9. La pièce de micromécanique 51'' ainsi fabriquée est libre par rapport au reste du substrat 3. Elle comporte, comme visible à la figure 12, ainsi, sur une couche unique comportant une partie 53" en silicium ou en silicium et en oxyde de silicium dont au moins un portion d'une des cavités 45" comporte une partie 41'' métallique.

Dans un deuxième mode de réalisation illustré à la figure 8, on voit que par exemple que l'étape de libération 33 du procédé 1 est réalisée après l'étape 31 de construction de la deuxième partie 65 en silicium comme visualisé par les doubles traits à la figure 10. L'étape de libération 33 consiste alors à éliminer les parties 71, 73 et 75 de résine photostructurée par exemple au moyen d'une attaque chimique et/ou mécanique (qui peut être une méthode connue par le terme anglais « stripping »). La pièce de micromécanique 51 ainsi fabriquée est libre par rapport au reste du substrat 3. Elle comporte ainsi, sur trois couches empilées, une deuxième partie 39 métallique, une partie 53 en silicium et en oxyde de silicium dont au moins une portion d'une des cavités 45 comporte une partie 41 métallique et une deuxième partie 65 en silicium.

La pièce de micromécanique 51 obtenue selon ledit deuxième mode de réalisation du procédé 1 expliqué ci-dessus et en relation avec les figures 1 à 8 et 10 comporte sensiblement un empilement consécutif de trois parties du type roue respectivement 39, 53 & 65 comportant une denture 59, 55 & 67. Cette pièce 51 est préférentiellement adaptée pour former une roue d'échappement destinée à coopérer avec une ancre d'échappement du type coaxial. Les dentures 55 et 67 en silicium sont alors avantageusement destinées à former les dentures d'impulsion destinées à coopérer avec les palettes de ladite ancre. La denture 59 métallique sert alors de pignon d'échappement destiné à réguler le mouvement auquel appartient la pièce de micromécanique 51.

Dans un troisième mode de réalisation illustré à la figure 9, on voit par exemple que l'étape de libération 33 du procédé 1 est réalisée après l'étape 25' de construction de la deuxième partie supplémentaire 39' métallique comme visualisé par les triples traits à la figure 10. L'étape de libération 33 consiste alors à éliminer non seulement les parties 71, 73 et 75 de résine photostructurée sur la partie supérieure du substrat 3 mais également celles présentes sur la couche inférieure dudit substrat. La pièce de micromécanique 51' ainsi fabriquée est libre par rapport au reste du substrat 3.

La pièce de micromécanique 51' comporte ainsi, comme visible à la figure 11, sur quatre couches empilées, une deuxième partie 39 métallique, une partie 53 en silicium et en oxyde de silicium dont au moins une portion d'une des cavités 45 comporte une partie 41 métallique, une deuxième partie 65 en silicium dont au moins une portion d'une des cavités 47 comporte une partie supplémentaire 41' métallique et une deuxième partie supplémentaire 39' métallique.

La pièce de micromécanique 51' obtenue selon ledit troisième mode de réalisation du procédé 1 expliqué ci-dessus et en relation avec les figures 1 à 7 et 9 à 11 comporte sensiblement un empilement consécutif de quatre couches du type roue respectivement 39, 53, 65 & 39' comportant une denture 59, 55, 67 & 59'.

Dans tous ces modes de réalisation, les pièces de micromécanique 51, 51', 51'' sont avantageusement chassées non pas directement sur une partie 53 & 65 en silicium mais sur les parties métalliques 39, 39', 41 et 41'. Préférentiellement afin que, notamment, la partie métallique 41 isole suffisamment la partie 53 en silicium, l'épaisseur est supérieure à 6 microns. En effet, au-delà de cette épaisseur et idéalement à partir de 10 microns, un métal comme par exemple le nickel est capable d'absorber élastiquement ou plastiquement les efforts sans les restituer au silicium.

Il faut comprendre à la lecture de l'explication ci-dessus que les pièces de micromécanique 51, 51', 51" des figures ne sont que des exemples de réalisation qui montre que le procédé 1 permet de réaliser un empilement jusqu'à quatre couches (deux comportant du métal et deux comportant du silicium et du métal) sans complications excessives. La configuration du premier mode de réalisation pourrait ainsi constituer la plus simple des pièces de micromécanique et, celle du troisième mode de réalisation, une complication haute.

Dans une variante visualisé en traits interrompus courts à la figure 10, l'étape 29, réalisée entre les étapes 21 et 23, consistant à déposer la couche d'accrochage 61 peut être déplacée entre les étapes 15 et 17, c'est-à-dire entre l'attaque chimique de la couche intermédiaire 9 et le dépôt de la couche de résine photosensible 57. Préférentiellement, dans cette première variante, on choisira de doper les deux couches en silicium 5 et 7.

Bien entendu, la présente invention ne se limite pas à l'exemple illustré mais est susceptible de diverses variantes et modifications qui apparaîtront à l'homme de l'art. En particulier, d'autres couches 63 métalliques peuvent être envisagées comme par exemple de l'or, de l'aluminium, du chrome ou un de leur alliages. De même, d'autres couches d'accrochage 61 peuvent être envisagées si elles sont conductrices et qu'elles adhèrent parfaitement au métal choisi pour la couche 63 de croissance galvanique. Cependant, il est à noter que l'étape 29 de dépôt de la couche 61 n'est pas essentielle au bon déroulement de la croissance galvanique si les deux couches en silicium 5 et 7 sont dopées.

De même d'autres motifs que les dentures 55, 59, 59' & 67 peuvent être gravés comme des crochets ou des cliquets. Il est également à noter que la couche 63 peut être réalisée contre lesdits motifs gravés tels que les dentures 55, 59, 59' & 67 par exemple.

De même, la photolithographie peut, bien sûr, former une structure en négatif ou en positif suivant la résine photosensible employée ou l'application prévue. Le dépôt de la couche de résine 57 peut également être envisagé d'être réalisé par un processus connu sous le terme anglais de « spray coating ».

Enfin, la couche 63 métallique peut être réalisée aussi bien sur une portion de paroi intérieure d'une cavité 45 que sur la paroi périphérique d'au moins une des parties en silicium 53 et 65. La couche 63 peut également être structurée afin qu'elle soit reliée à ladite paroi en silicium par l'intermédiaire de ponts de matière.

## Revendications

1. Procédé de fabrication (1) d'une pièce de micromécanique (51, 51', 51 ") composite silicium - métal comprenant les étapes suivantes :
a) se munir (11) d'un substrat (3) comportant une couche supérieure (5) et une couche inférieure (7) en silicium entre lesquelles s'étend une couche intermédiaire (9) d'oxyde de silicium ;
b) graver (13) sélectivement au moins une cavité (37, 45, 45") dans la couche supérieure (5) pour définir le motif d'une partie (53, 53") en silicium de ladite pièce ;
c) continuer la gravure (15) de ladite au moins une cavité (37, 45, 45") dans la couche intermédiaire (9) ;
**caractérisé en ce qu'**il comporte en outre les étapes suivantes :
d) faire croître (17, 21, 23) une couche métallique (63) au moins à partir d'une portion de ladite au moins une cavité (37, 45, 45") afin de former une partie (41, 41', 41") métallique dans l'épaisseur de ladite pièce ;
e) libérer (33) la pièce de micromécanique (51, 51', 51") composite silicium - métal du substrat (3).

2. Procédé (1) selon la revendication 1, **caractérisé en ce que** l'étape d) comporte les étapes suivantes :
- recouvrir (17) de résine photosensible (57) le dessus du substrat (3) ;
- réaliser (21) sélectivement une photolithographie de la résine photosensible (57) afin de la photostructurer (71, 73, 75) en fonction du motif prédéterminé de la partie (39, 41) métallique ;
- déposer (23) une couche métallique par électrodéposition à partir de la face supérieure conductrice de la couche inférieure (7) qui est à l'aplomb de ladite au moins une cavité (37, 45, 45") en y faisant croître, à partir du fond, la couche (63) entre respectivement la résine photostructurée (75) et la couche intermédiaire (9) ou supérieure (5) permettant de former la partie métallique (41, 41', 41'') selon ledit motif ; et **en ce que** l'étape e) est réalisée en éliminant (33) la résine photostructurée (71, 73, 75).

3. Procédé (1) selon la revendication 2, **caractérisé en ce que** ladite face supérieure conductrice de la couche inférieure (7) qui est à l'aplomb de ladite au moins une cavité (37, 45, 45") est rendue conductrice par dopage de la couche inférieure (7) et/ou par dépôt (29) d'une couche conductrice (61).

4. Procédé (1) selon la revendication 2 ou 3, **caractérisé en ce que** la résine photostructurée (71, 73, 75) lors de l'étape (21) de photolithographie fait saillie (73, 75) de la couche supérieure (5) du substrat (3) afin de pouvoir continuer la croissance de la couche (63) par électrodéposition (23) au moins entre lesdites saillies de la résine (73, 75) photostructurée dans le but de former une deuxième partie métallique (39) de la pièce de micromécanique (51, 51') au-dessus de la partie (53) en silicium.

5. Procédé (1) selon l'une des revendications précédentes,
**caractérisé en ce qu'**il comporte, après l'étape d), une étape (25) d'usinage de la face supérieure du substrat (3) afin de niveler la couche métallique (63) à la même hauteur que l'extrémité supérieure de ladite résine photostructurée (73, 75).

6. Procédé (1) selon l'une des revendications précédentes,
**caractérisé en ce que** la couche métallique (63, 39, 39', 41, 41', 41") comporte du nickel.

7. Procédé (1) selon l'une des revendications précédentes,
**caractérisé en ce qu'**il comporte, avant l'étape de libération (33), des étapes d'usinage (27) et de gravage (31) d'au moins une cavité (47, 49) dans la couche inférieure (7) du substrat (3) afin de former une seconde partie (65) en silicium de la pièce de micromécanique (51, 51') selon une forme et une épaisseur déterminée.

8. Procédé (1) selon la revendication 7, **caractérisé en ce qu'**il comporte, entre les étapes (27, 31) d'usinage et de gravage de la couche inférieure (7) du substrat (3) et l'étape de libération (33), une étape (17', 21', 23') de croissance d'une deuxième couche métallique (41') par électrodéposition dans au moins une portion de ladite au moins une cavité (47) de la couche inférieure (7) afin de former au moins une partie métallique (41') supplémentaire dans l'épaisseur de la couche inférieure (7).

9. Procédé (1) selon la revendication 8, **caractérisé en ce que** l'étape de croissance comporte les étapes suivantes :
- recouvrir (17') de résine photosensible le dessous du substrat (3) ;
- réaliser (21') sélectivement une photolithographie de la résine photosensible afin de la photostructurer en fonction du motif prédéterminé de la partie (41') métallique ;
- déposer (23') une couche métallique par électrodéposition à partir du fond de ladite au moins une cavité (47) en y faisant croître, à partir du fond, la couche permettant de former la partie métallique (41') selon ledit motif ;

10. Procédé (1) selon la revendication 9, **caractérisé en ce que** la résine photostructurée lors de l'étape (21') de photolithographie fait saillie de la couche inférieure (7) du substrat (3) afin de pouvoir continuer la croissance de la couche par électrodéposition (23') dans le but de former une deuxième partie métallique (39') supplémentaire de la pièce de micromécanique (51') en dessous de la deuxième partie (65) en silicium.

11. Procédé (1) selon l'une des revendications précédentes,
**caractérisé en ce qu'**il comporte, avant l'étape (33) de libération, une étape (25') d'usinage de la face inférieure du substrat (3) afin de niveler la partie métallique (39') à la même hauteur que l'extrémité inférieure de ladite résine photostructurée.

12. Procédé (1) selon l'une des revendications 8 à 11, **caractérisé en ce que** la deuxième couche métallique électrodéposée (39', 41') comporte du nickel.

13. Procédé (1) selon l'une des revendications précédentes,
**caractérisé en ce que** plusieurs pièces de micromécanique (51, 51', 51'') sont fabriquées sur le même substrat (3).

14. Pièce de micromécanique (51, 51', 51") composite silicium - métal comportant une partie (53, 53") formée dans une couche (5) en silicium **caractérisée en ce que** ladite partie en silicium comporte, au moins sur une portion de son épaisseur, une partie (39, 41, 41 ") métallique d'une épaisseur supérieure à 6 microns destinée à isoler la partie (53, 53") en silicium d'efforts destructifs.

15. Pièce de micromécanique selon la revendication 14,
**caractérisée en ce que** la partie métallique forme une chemise qui recouvre la paroi périphérique de ladite partie en silicium.

16. Pièce de micromécanique selon la revendication 15,
**caractérisé en ce que** ladite chemise est reliée à ladite paroi périphérique par des ponts de matière.

17. Pièce de micromécanique selon la revendication 15 ou 16,
**caractérisée en ce que** ladite partie métallique comporte dans son prolongement une deuxième partie métallique faisant saillie de ladite partie en silicium.

18. Pièce de micromécanique selon la revendication 14,
**caractérisée en ce que** la partie métallique forme une chemise (41, 41") dans une cavité (45, 45") réalisée dans la partie (53, 53") en silicium afin de recevoir par chassage un axe de pivotement.

19. Pièce de micromécanique selon la revendication 18,
**caractérisé en ce que** ladite chemise est reliée à la paroi de ladite cavité par des ponts de matière.

20. Pièce de micromécanique selon la revendication 18 ou 19,
**caractérisée en ce que** la partie métallique (41) comporte dans son prolongement une deuxième partie (39) métallique faisant saillie de la partie (53) en silicium.

21. Pièce de micromécanique selon la revendication 20,
**caractérisée en ce que** la deuxième partie (39) métallique comporte une denture (59) afin de former une roue ou un pignon.

22. Pièce de micromécanique selon l'une des revendications 14 à 21, **caractérisée en ce que** chaque partie (63, 39, 41, 41") métallique comportent du nickel.

23. Pièce de micromécanique selon l'une des revendications 14 à 22, **caractérisée en ce que** la partie (53) en silicium comprend une denture (55) afin de former une roue ou un pignon.

24. Pièce de micromécanique selon l'une des revendications 14 à 23, **caractérisée en ce qu'**elle comporte une deuxième partie (65) en silicium formée à partir d'une deuxième couche (7).

25. Pièce de micromécanique selon la revendication 24,
**caractérisée en ce que** la deuxième partie (65) en silicium comporte au moins sur une portion de son épaisseur une partie supplémentaire (41') métallique destinée à isoler la deuxième partie (65) en silicium d'efforts destructifs.

26. Pièce de micromécanique selon la revendication 25,
**caractérisée en ce que** la partie supplémentaire métallique forme une chemise (41') dans une cavité (47) réalisée dans la deuxième partie (65) en silicium afin de recevoir par chassage un axe de pivotement.

27. Pièce de micromécanique selon la revendication 26,
**caractérisé en ce que** ladite chemise est reliée à la paroi de ladite cavité par des ponts de matière.

28. Pièce de micromécanique selon l'une des revendications 25 à 27, **caractérisée en ce que** la partie supplémentaire (41') métallique comporte dans son prolongement une deuxième partie supplémentaire (39') métallique faisant saillie de la deuxième partie (65) en silicium.

29. Pièce de micromécanique selon la revendication 28,
**caractérisée en ce que** la deuxième partie supplémentaire (39') métallique comporte une denture (59') afin de former une roue ou un pignon.

30. Pièce de micromécanique selon l'une des revendications 25 à 29, **caractérisée en ce que** chaque partie métallique (39', 41') comportent du nickel.

31. Pièce de micromécanique selon l'une des revendications 25 à 30, **caractérisé en ce que** la deuxième partie (65) en silicium est montée sur la partie (53) en silicium à l'aide d'une couche intermédiaire (9) en oxyde de silicium.

32. Pièce de micromécanique selon l'une des revendications 25 à 31, **caractérisée en ce que** la deuxième partie (65) en silicium comprend une denture (67) afin de former une roue ou un pignon.

33. Pièce d'horlogerie **caractérisée en ce qu'**elle comporte au moins une pièce de micromécanique (51, 51', 51") conforme à l'une des revendications 14 à 32.
